# EUROPEAN PATENT SPECIFICATION

(11) **EP 2 792 719 B1**
(45) Date of publication and mention of the grant of the patent: **21.12.2016**
(21) Application number: 14164719.8
(22) Date of filing: 15.04.2014
(51) Int. Cl.: C09D 7/14, H01S 5/024, H01L 23/373, C09D 1/00

(54) **Method of manufacturing a spacer - graphene heat-spreader, in electronic power devices, especially in laser diodes**
Verfahren zur Herstellung eines Abstandsstück-Graphen-Heat-Spreaders, in elektronischen Leistungsschaltungen, insbesondere in Laserdioden
Procédé de fabrication d'un espaceur - dissipateur thermique au graphène dans des dispositifs à alimentation électronique, en particulier dans des diodes laser

(30) Priority: 15.04.2013 PL 40354913
(43) Date of publication of application: 22.10.2014
(73) Proprietor: Instytut Technologii Materialów Elektronicznych, 01-919 Warszawa (PL)
(72) Inventor: Teodorczyk, Marian, 01-926 Warszawa (PL); Dabrowska - Tumanska, Elzbieta, 01-494 Warszawa (PL); Jakubowska, Malgorzata, 02-541 Warszawa (PL); Malag, Andrzej, 01-227 Warszawa (PL); Mlozniak, Anna, 01-737 Warszawa (PL)
(74) Representative: Sielewiesiuk, Jakub

(56) References cited:
- EP-A1- 2 570 462
- US-A1- 2010 085 713

## Description

The object of the invention is a method of manufacturing a spacer - graphene heat-spreader, in electronic power devices, especially in laser diodes. The invention relates to manufacturing technology of electronic power devices, especially laser diodes of medium and high optical power.

In semiconductor power devices, which include laser diodes, lasers, power diodes, transistors, thyristors, triacs, part of the energy is converted into heat during their operation. This heat is removed by coolers - radiators. Semiconductor structures, so-called chips, are attached to the coolers by soldering method, mostly using metal eutectic solders. These are, among others, laser diodes of medium and high optical power. Process of mounting laser chips to coolers consists in soldering the chip by means of an indium solder to spacers dissipating heat and additionally adjusting the coefficient of thermal expansion to the materials of which the chip's substrates are made. Such spacers are known as "heat-spreaders". These spacers are soldered to coolers.

Therefore, in the mounting technology of semiconductor structures emitting a considerable amount of heat, the above described spacers allowing, among others, very fast heat removal, so-called "heat-spreaders", are used. They are also used in the mounting of semiconductor lasers. During operation of the semiconductor laser, the ability to dissipate heat from the active area is a critical characteristic responsible for its parameters and lifetime. Stresses in the structure of laser chip are not a less important phenomenon introduced by soldering processes because any mounting method introduces stresses into the heterostructure of laser diode. It is important what part of this stress is transferred to its quantum well. Influence of the stress manifests itself, among others, in the light-current characteristics of laser diode: efficiency decrease and threshold current increase i.e. generally worsening of electro-optical parameters of the laser diode. Stress can also be seen in the position of spectral characteristics - the characteristics shift toward shorter wavelengths in the case of mounting the laser chip directly on the copper (Cu) cooler. In part these problems have been alleviated by the use of spacers ("heat-spreaders") made of CuC alloy having their coefficient of thermal expansion adjusted to gallium arsenide - GaAs - a base material of the heterostructure of semiconductor lasers emitting in the wavelength range of 630 nm to 1 µm and having a high thermal conductivity.

The CuC spacers are very expensive, and attempts to retrieve them from damaged components are ineffective.

Therefore, the aim of the present invention is to propose an alternative method of manufacturing the heat dissipating layer ("heat-spreader") in electronic power devices, especially in laser diodes, devoid of above disadvantages.

For this purpose, attempts were made in the manufacturing process to use a heat dissipating layer (graphene "heat spreader") based on graphene suspension.

From Polish Patent Application No. P-396373, a paste containing 0.5 wt.% to 15 wt.% of graphene nanoplatelets mixed with an organic carrier in the form of polymethyl methacrylate (PMMA) solution in butylcarbitol acetate having a concentration of 2 wt.% to 10 wt.% or in the form of polycarbonate (PC) solution in butylcarbitol acetate having a concentration of 5 wt.% to 12 wt.% is known. Preliminary tests were carried out using this kind of graphene paste. The measurements have shown, however, that the thermal conductivity was not satisfactory.

Surprisingly, it turned out that very good results are obtained by eliminating from the composition of such a paste a polymer (i.e. PMMA or PC, accordingly), i.e. by replacing the paste with graphene nanoplatelets suspension in butylcarbitol acetate.

According to the invention, the method of manufacturing a spacer - graphene heat-spreader in electronic power devices, especially in laser diodes, is characterised in that it comprises the steps of:
a) deposition on the radiator of the said electronic power device, and especially, on the semiconductor laser cooler a suspension consisting of graphene nanoplatelets in the amount of 3 wt.% to 20 wt.% in butyl carbitolacetate until a layer having a thickness of 20µm to 200µm is obtained,
b) drying the obtained layer at room temperature in the air for a time of 10 to 20 minutes,
c) drying the obtained layer in a tunnel dryer at a temperature of about 120°C for a time of 10 to 20 minutes.

Preferably, the content of graphene nanoplatelets in the said suspension is 5 wt.%.

Preferably, in step a) the suspension is applied by a technique selected from: brush painting, spray coating, rotogravure, screen printing.

Preferably, the obtained layer is additionally covered with a layer of indium (In) having a thickness of 5 µm to 50 µm.

It turns out that the use of graphene suspension under the indium solder not only does not deteriorate diode parameters, but, in pulsed operation, actually reduces the threshold current and improves the efficiency - the slope of light-current characteristics increases. Changes in both of these electro-optical parameters are very beneficial to the operation of the laser diode. They are the result of good evacuation of heat from the chip area and of minimum stresses introduced by the assembly process.

### Detailed Description of the Invention

Now, the invention will be presented in greater detail in preferred embodiments, with reference to the accompanying drawings in which:

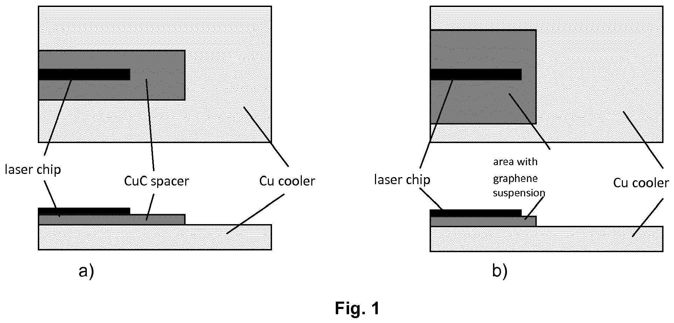

- Fig. 1: (a, b) shows a scheme of a laser diode with a traditional heat-spreader in the form of CuC plate (a) and a scheme of a diode with a heat-spreader layer made according to the method of the invention (b),
- fig. 2: shows microscopic images of graphene nanoplatelets (GNP) used in the invention being described.
- fig. 3: shows spectral (at different currents) and light-current characteristics in cw measurements, for the laser diode mounted on the graphene paste (graphene heat spreader) and on the copper cooler, at various stages of mounting,
- fig. 4: shows, for comparison, spectral (at different currents) and light-current characteristics in cw measurements, for the laser diode soldered directly on the copper cooler, at various stages of mounting.
- .fig. 5: shows, for comparison, spectral characteristics (at different currents), of the laser diode with a traditional heat-spreader in the form of CuC plate.

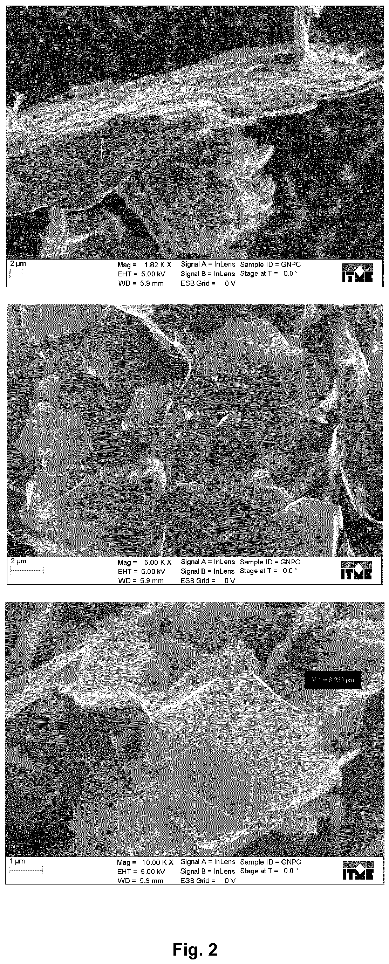

The same graphene nanoplatelets as those described in application P - 396373 are used. Microscopic images of GNP used in the described tests are shown in Fig. 2.

A suspension of graphene nanoplatelets in butylcarbitol acetate was prepared. 3 wt.% to 20 wt.% of nanoplatelets was used, wherein the density optimal for depositing was obtained with a content of 5 wt.% of nanoplatelets (with a size of 15 µm x 15 µm and a thickness of 3 - 20 graphene layers). Appropriate dispersion of graphene nanoplatelets was obtained by acting on the suspension with ultrasounds for 1-2 hours.

Surfaces preparation of gold-electroplated elements - laser coolers - consisted in washing them in acetone. The suspension was deposited with a brush on the heat-absorbing-surface of successive elements. The aim was to obtain a continuous, possibly thick layer, by brush painting, without any apparent defects or clearances.

Suspension layers with thicknesses of 20 - 200 µm were deposited on laser coolers. Drying in the air for 10 - 20 minutes constituted a levelling phase, i.e. it allowed the suspension to dissolute and smooth its surface. Then, drying in a tunnel dryer at a temperature of 120°C for 10 - 20 minutes was carried out. The so prepared layers showed satisfactory thermal conductivity.

Then, these layers were covered, using resistive vacuum evaporation technique, with an indium (In) layer having a thickness of 5 - 50 µm. Laser chips were attached by means of them in a specially designed thermal process, using the "flip-chip" soldering station. Soldering tests were successful; when trying to tear the chips from the coolers, they became damaged, which indicated the correct attachment. This was also confirmed by light-current and spectral characteristics of so prepared laser diodes.

Alternative methods for the suspension deposition include spray coating, rotogravure, screen printing and other printing techniques.

### Conclusions

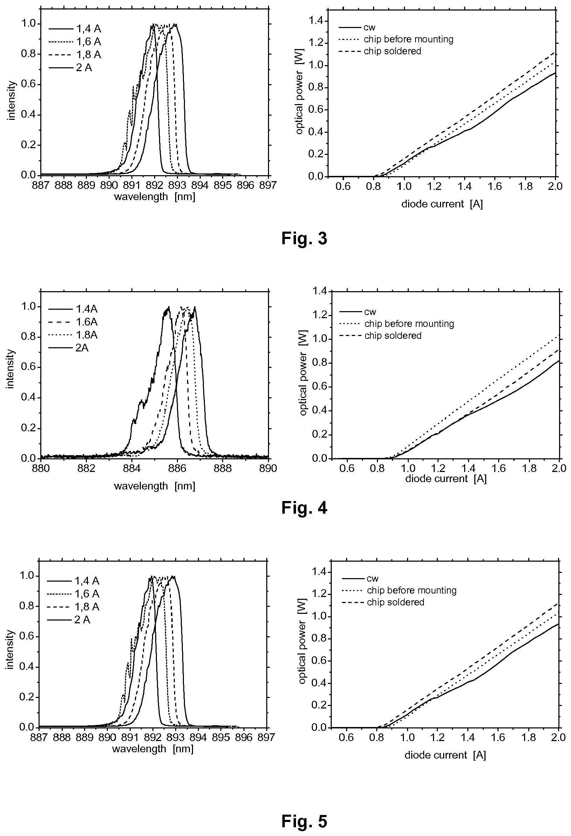

A suspension with nanographene and a method of deposition, from it, layers of repetitive thickness on laser coolers has been elaborated. Suspension layers were deposited on laser coolers and, using resistive vacuum evaporation technique, they were covered with a layer of indium (In), and then laser chips were attached by means of them (in a special thermal process). Tests were successful; when trying to tear the chips from the coolers, they became damaged, which indicated the correct attachment. The beneficial effect of graphene heat-spreaders made of such suspensions was also confirmed by light-current and spectral characteristics shown in Fig. 3, Fig. 4. Graphene heat-spreaders made of graphene suspension according to the invention have the same preferred characteristics as the traditional heat-spreaders in the form of plate (Fig. 5).

## Claims

1. A method of manufacturing a spacer - graphene heat-spreader, in electronic power devices, especially in laser diodes, **characterised in that** it comprises the steps of:
a) deposition on the radiator of the said electronic power device, and especially, on the semiconductor laser cooler a suspension consisting of graphene nanoplatelets in the amount of 3 wt.% to 20 wt.% in butylcarbitol acetate until a layer having a thickness of 20 µm to 200 µm,
b) drying the obtained layer at room temperature in the air for a time of 10 to 20 minutes,
c) drying the obtained layer in a tunnel dryer at a temperature of about 120°C for a time of 10 to 20 minutes.

2. The method according to claim 1, **characterised in that** the content of graphene nanoplatelets in the said suspension is 5 wt.%.

3. The method according to claim 1 or 2, **characterised in that** in step a) the suspension is deposited by a technique selected from: brush painting, spray coating, rotogravure, screen printing.

4. The method according to any one of the preceding claims, **characterised in that** the obtained layer is additionally covered with a layer of indium (In) having a thickness of 5 µm to 50 µm.

## Patentansprüche

1. Verfahren zur Herstellung eines Spacer - Graphen-Wärmespreizers in elektronischen Leistungsvorrichtungen, insbesondere in Laserdioden, **dadurch gekennzeichnet, dass** es die folgenden Schritte umfasst:
a) Ablagerung auf dem Heizkörper der genannten elektronischen Leistungsvorrichtung und insbesondere auf dem Halbleiterlaserkühler mit einer Suspension, bestehend aus Graphen-Nanoplättchen in einer Menge von 3 Gew.% bis 20 Gew.% in Butylcarbinolacetat bis einer Schicht mit der Dicke von 20 µm bis 200 µm,
b) Trocknen der erhaltenen Schicht bei Raumtemperatur in der Luft für eine Zeit von 10 bis 20 Minuten,
c) Trocknen der erhaltenen Schicht in einem Tunneltrockner bei einer Temperatur von etwa 120°C für eine Zeit von 10 bis 20 Minuten.

2. Verfahren nach Anspruch 1, **dadurch gekennzeichnet, dass** der Gehalt an Graphen-Nanoplättchen in der genannten Suspension 5 Gew-% beträgt.

3. Verfahren nach Anspruch 1 oder 2, **dadurch gekennzeichnet, dass** in Schritt a) die Suspension durch eine aus: Pinselmalerei, Sprühbeschichtung, Tiefdruck, Siebdruck ausgewählte Technik, abgelagert wird.

4. Verfahren nach einem der vorstehenden Ansprüche, **dadurch gekennzeichnet, dass** die erhaltene Schicht zusätzlich mit einer Schicht aus Indium (In) mit einer Dicke von 5 µm bis 50 µm bedeckt wird.

## Revendications

1. Un procédé de fabrication d'une entretoise - un dissipateur thermique de graphène, dans les dispositifs électroniques de puissance, en particulier dans les diodes lasers, **caractérisé en ce qu'**il comprend les étapes suivantes :
a) dépôt sur le radiateur dudit dispositif électronique de puissance, et plus particulièrement, sur le refroidisseur laser à semi-conducteur, d'une suspension constituée de nanoplaquettes de graphène en une quantité de 3% en poids à 20% en poids, dans l'acétate de butylcarbinol jusqu'à ce qu'on obtient une épaisseur de couche de 20 µm à 200 µm,
b) séchage de la couche obtenue à la température ambiante dans l'air pendant une durée de 10 à 20 minutes,
c) séchage de la couche obtenue dans un séchoir à tunnel à une température d'environ 120°C pendant une durée de 10 à 20 minutes.

2. Le procédé selon la revendication 1, **caractérisé en ce que** le contenu des nanoplaquettes de graphène dans ladite suspension est égal à 5 % en poids.

3. Le procédé selon la revendication 1 ou 2, **caractérisé en ce qu'**à l'étape a), la suspension est déposée par une technique choisie parmi: peinture au pinceau, enduction par pulvérisation, rotogravure, sérigraphie.

4. Le procédé selon l'une quelconque des revendications précédentes, **caractérisé en ce que** la couche obtenue est en plus recouverte d'une couche d'indium (In) ayant une épaisseur de 5 µm à 50 µm.
